# EUROPEAN PATENT SPECIFICATION

(11) **EP 4 298 349 B1**
(45) Date of publication and mention of the grant of the patent: **28.10.2026**
(21) Application number: 22710237.3
(22) Date of filing: 24.02.2022
(51) Int. Cl.: F04D 1/00, F04D 13/06, F04D 29/62, F04B 49/00

(54) **USER INTERFACE FOR PUMPS FOR SWIMMING POOLS AND SPAS**
BENUTZERSCHNITTSTELLE FÜR PUMPEN FÜR SCHWIMMBECKEN UND SPAS
INTERFACE UTILISATEUR POUR POMPES POUR PISCINES ET SPAS

(30) Priority: 25.02.2021 US 202163153766 P
(43) Date of publication of application: 03.01.2024
(60) Divisional application: 26180535.2 / 4 772 747
(73) Proprietor: Zodiac Pool Systems LLC, Carlsbad, California 92010 (US)
(72) Inventor: BOLANE, Jesse, San Marcos, California 92069 (US); GOLMAN, Matthew, San Marcos, California 92069 (US); NUGENT, Merinda, Vista, California 92083 (US); JONES, Steven, Alan, San Marcos, California 92078 (US); MOMONT, Alec, San Francisco, California 94117 (US); SERVAITES, Jeffrey, Oakland, California 94602 (US); STARLING, Ryan, San Rafael, California 94903 (US); HSIEH, Kenneth, Seattle, Washington 98121 (US); FORTE, Paolo, Boston, Massachusetts 02115 (US)
(74) Representative: Weickmann & Weickmann PartmbB
(86) International application number: PCT/US2022/017620
(87) International publication number: WO 2022/182819

(56) References cited:
- WO-A1-2011/106530
- WO-A1-2016/087595
- WO-A2-2008/073436
- US-A1- 2010 216 527
- US-A1- 2014 251 002

## Description

### REFERENCE TO RELATED APPLIKATION

### FELD OF THE INVENTION

This invention relates to pumps for moving fluid in bodies of water such as, but not necessarily limited to, swimming pools and spas and, more particularly, to user interfaces for such pumps.

### BACKGROUND OF THE INVENTION

Pumps can be configured to move fluid. For example, pumps used with swimming pools, spas, well pumps, septic systems, and other bodies of water may displace existing fluid. The pumps may be pre-programmed, or may use input from a user for determining operations to perform relating to moving the fluid. A user interface can be provided for pumps that use input from a user.
WO 2011/106530 A1 discloses a variable speed pump assembly for connection to a fluid circulation line of a swimming pool and/or other recreational body of water, such as a spa, etc. The variable speed pumping assembly includes a pump, a variable speed motor in communication with the pump, and a drive assembly sized to control the variable speed motor. A user interface is selectively positionable among a plurality of positions with respect to the pump, variable speed motor, and/or the drive assembly
WO 2008/073436 A2 discloses a pumping system for moving water of a swimming pool. The pumping system includes a water pump for moving water in connection with performance of an operation upon the water. A variable speed motor is operatively connected to drive the pump. The pumping system further includes a means for controlling the variable speed motor. An auxiliary device as a part of the pumping system is operably connected to the means for controlling, and the system also includes a means for providing two-way communication between the means for controlling and the auxiliary device.
The means for controlling receives a parameter from the auxiliary device through the means for providing two-way communication, and is capable of independently controlling the variable speed motor without receipt of a parameter from the auxiliary device.
A yet another pump unit, for example, a centrifugal pump, is known from WO 2016/087595 A1. An electronic converter unit is arranged external to the pump unit, and the latter includes a housing, comprising a signal source for emitting a signal.
US 2014/0251002 A1 discloses a fluid meter for water, including a totalizer having an upper electronic card with a metering screen. The totalizer is covered by a cap having an external window for viewing the screen. A screen cover is mounted on the cap to cover and protect the screen and the external window. The electronic card of the meter is provided with a device for detection of the open or closed position of the screen cover. This detection of the open or closed position controls scrolling of the data of the screen.
US 2010/0216527 A1 teaches an electronic device assumed to be suitable as a user interface for a fluid-moving pump. The electronic device comprises a top housing and a bottom housing. The top housing is slidable relative to the bottom housing between a closed position and an open position. In the open position the top housing reveals or uncovers a first portion of the face of the bottom housing and covers a second portion of the face of the bottom housing. In the closed position the top housing covers both the first and second portions of the face of the bottom housing.

### SUMMARY

Embodiments covered by this patent are defined by the claims below, not this summary. This summary is a high-level overview of various embodiments and introduces some of the concepts that are further described in the Detailed Description section below.
This summary is not intended to identify key or essential features of the claimed subject matter, nor is it intended to be used in isolation to determine the scope of the claimed subject matter. The subject matter should be understood by reference to appropriate portions of the entire specification of this patent, any or all drawings, and each claim.

The present invention provides a user interface for a fluid-moving pump having the features of claim 1 and a method associated with a user interface for a fluid-moving pump having the features of claim 10. According to the invention, a user interface for a fluid-moving pump includes at least two interface regions and a cover for covering one of the at least two interface regions.

According to some embodiments, a user interface for a fluid-moving pump is attachable to the fluid-moving pump and without the use of tools.

According to various embodiments, a user interface for a fluid-moving pump includes at least two RS-485 connections for communicatively coupling the user interface to the fluid-moving pump and to an automation device.

According to certain embodiments, a user interface for a fluid-moving pump may be attachable on a wall or a pump such that the user interface is mounted on the wall or the pump and oriented into one of four or more predetermined orientations relative to the wall or the pump.

According to various embodiments, a user interface for the fluid-moving pump includes a magnet sensor for sensing whether the cover is open.

According to some embodiments, a method associated with the user interface includes sensing that a cover of an interactive region is open, displaying information relating to a fluid-moving pump, receiving user input via a user interface dial, and performing operations based on the received user input.

According to certain embodiments, a system includes a fluid-moving pump, a user interface, and a hinge for positioning the user interface on the fluid-moving pump. The hinge may be movable between an open position and a closed position to selectively allow access to an interior of the system housing wires connecting the user interface with the fluid-moving pump.

Various implementations described herein can include additional systems, methods, features, and advantages, which cannot necessarily be expressly disclosed herein but will be apparent to one of ordinary skill in the art upon examination of the following detailed description and accompanying drawings. It is intended that all such systems, methods, features, and advantages be included within the present disclosure and protected by the accompanying claims.

### BRIEF DESCRIPTION OF THE DRAWINGS

FIGS. 1A-D illustrate various views of a user interface according to one or more examples of the present disclosure.
FIGS. 2A-C illustrate various perspective views of a pump and user interface assembly according to one or more examples of the present disclosure.
FIG. 3 illustrates an underside perspective view of the user interface of FIGS. 1A-D.
FIGS. 4A-B illustrate perspective views of the pump and user interface assembly of FIGS. 2A-C, with FIG. 4A illustrating the assembly in a closed position and FIG. 4B illustrating the assembly in an open position.
FIG. 5 illustrates another perspective view of the pump and user interface assembly of FIGS. 2A-C, shown in the open position, including an enlarged view taken at inset circle A.
FIGS. 6A-B illustrate additional perspective views of the pump and user interface assembly of FIGS. 2A-C, including an enlarged view taken at inset circle B.
FIGS. 7A-B illustrate two perspective views of another pump and user interface assembly according to one or more examples of the present disclosure.
FIGS. 8A-C illustrate various views of the pump and user interface assembly of FIGS. 7A-B.
FIGS. 9A-B illustrate a partial perspective view and a cross-sectional view of the pump and user interface assembly of FIGS. 7A-B.
FIGS. 10A-D illustrate portions of a wall mount user interface assembly and an exploded view of a wall mount user interface assembly according to one or more examples of the present disclosure.
FIGS. 11A-B illustrate two views of a user interface mounted on a wall according to one or more examples of the present disclosure.
FIG. 12 illustrates a cross-sectional view of the user interface of FIGS. 1A-D.
FIG. 13 is a flow chart of an exemplary process for operating a user interface that includes two or more interface regions.

### DETAILED DESCRIPTION

The subject matter of embodiments of the present invention is described here with specificity to meet statutory requirements, but this description is not necessarily intended to limit the scope of the claims. The claimed subject matter may be embodied in other ways, may include different elements or steps, and may be used in conjunction with other existing or future technologies. This description should not be interpreted as implying any particular order or arrangement among or between various steps or elements except when the order of individual steps or arrangement of elements is explicitly described.

Certain aspects and examples relate to a user interface that is communicatively coupled with a fluid-moving pump and that includes at least two interactive regions for receiving user input to control the fluid-moving pump. In some examples, the user interface may be attached to the fluid-moving pump using a mounting cover and an attachment bracket that can allow attachment or positioning of the user interface relative to the fluid-moving pump via a quarter-turn motion or other suitable methods. In other examples, the user interface can be mounted on a wall or other surface.

In some examples, the user interface can be attached to the fluid-moving pump in such a way that allows the user interface, once installed on the fluid-moving pump or the wall or other surface, to be rotated in a plurality of predetermined positions. In some examples, the user interface can be oriented/rotated into any of four predetermined positions. Additionally or alternatively, in some examples, the user interface can be attached to the fluid-moving pump via an attachment bracket that allows the user interface assembly to move between an open position, in which a user can access wiring of the user interface, and a closed position, in which access to wiring of the user interface is restricted.

According to the invention, the user interface includes at least two interactive regions, such as a covered region and an uncovered region. The uncovered region may include various buttons, dials, or other suitable components or areas for receiving user input to cause the fluid-moving pump to perform operations or otherwise adjust settings of the fluid-moving pump. The covered region may include an illuminated screen (as by LEDs, for example) that is usable to program custom functions of the fluid-moving pump and to perform other suitable operations relating to the fluid-moving pump. The covered region may also include various buttons, dials, or other suitable components or areas for receiving user input to cause the fluid-moving pump to perform operations or otherwise adjust settings of the fluid-moving pump. The covered region can be selectively covered by a movable cover.

Illustrative examples are given to introduce the reader to the general subject matter discussed herein and are not intended to limit the scope of the disclosed concepts. The following sections describe various additional features and examples with reference to the drawings in which like numerals indicate like elements, and directional descriptions are used to describe the illustrative aspects, but, like the illustrative aspects, should not be used to limit the present disclosure.

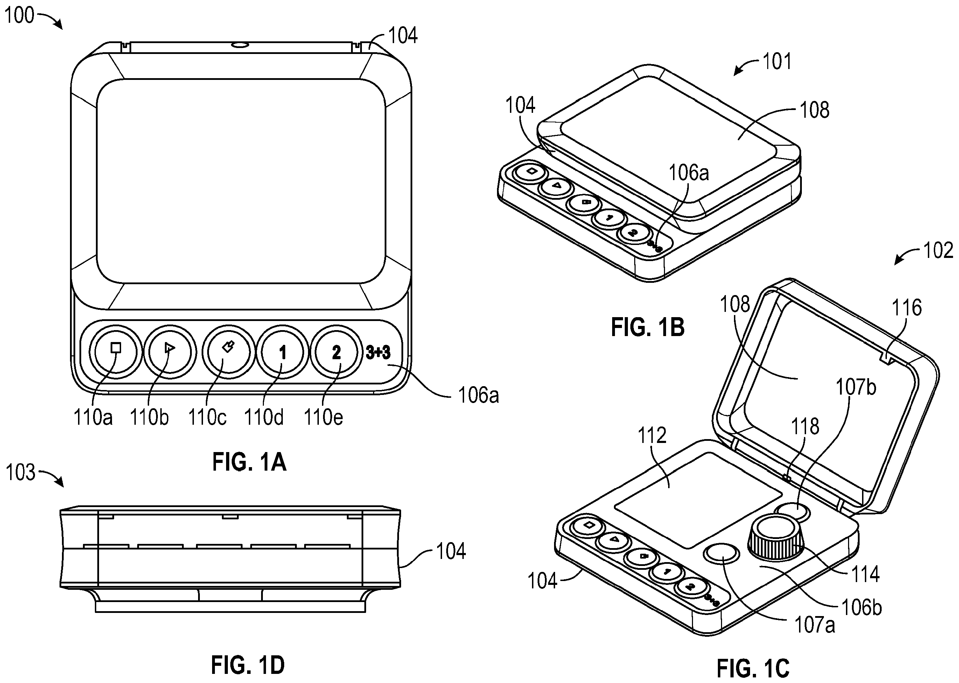

FIGS. 1A-D illustrate various views 100-103 of a user interface 104 according to one or more examples of the present disclosure. The view 100 of FIG. 1A is a top view of the user interface 104 in the closed position, the view 101 of FIG. 1B is a perspective view of the user interface 104 in the closed position, the view 102 of FIG. 1C is a perspective view of the user interface 104 in the open position, and the view 103 of FIG. 1D is a front view of the user interface 104.

As illustrated in FIGS. 1A-D, the user interface 104 includes a first interface region 106a, a second interface region 106b, and an interface cover 108. The interface cover 108 is selectively movable between a closed position (FIG. 1B) and an open position (FIG. 1C). In the closed position, the interface cover 108 selectively covers the second interface region 106b, and in the open position, a user may access both the first interface region 106a and the second interface region 106b. In this way, the user interface 104 functions as a dual user interface.

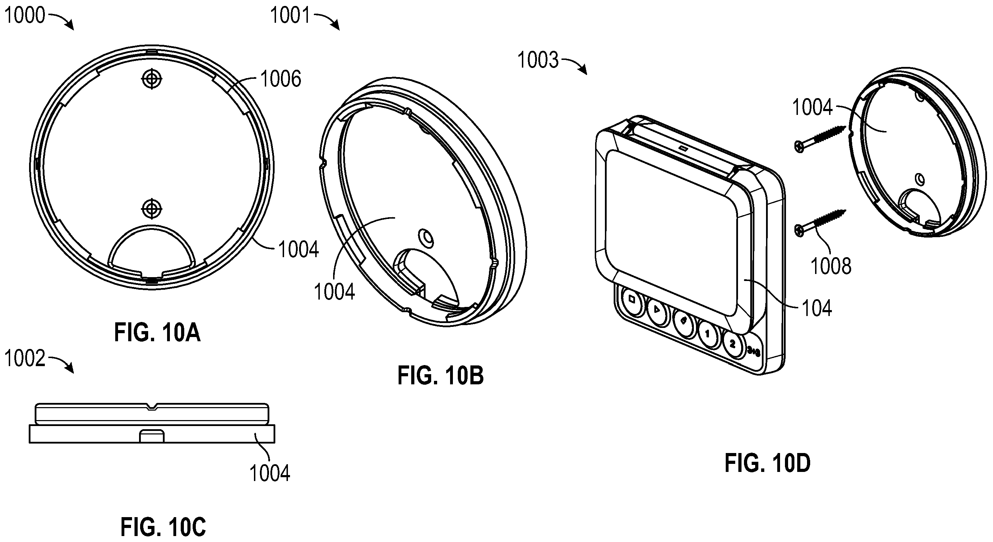

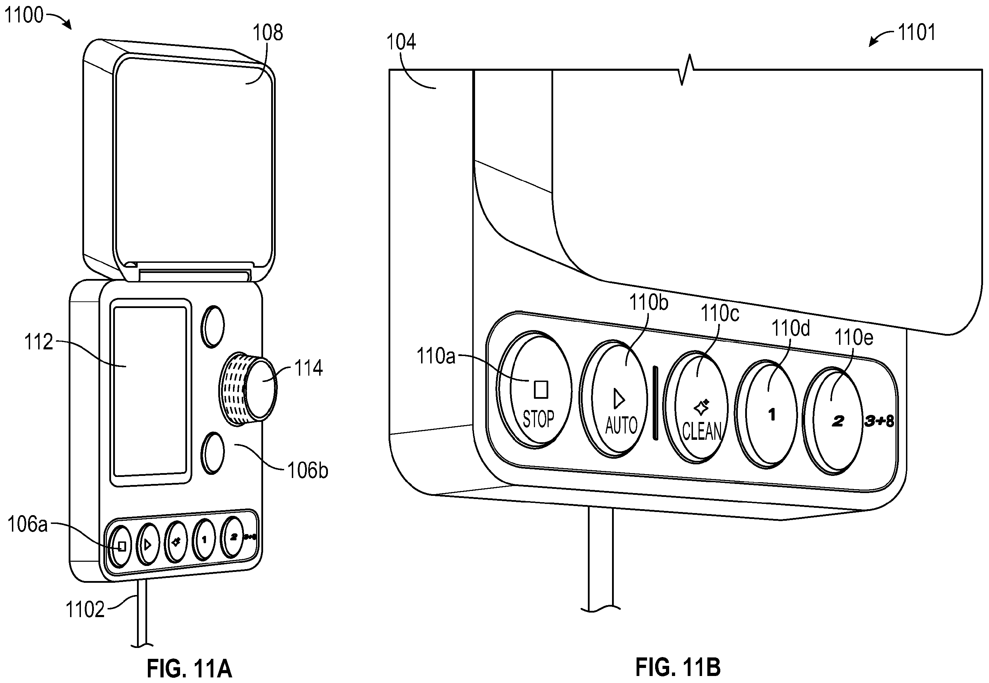

The user interface 104 may be installed on, or otherwise affixed to, a fluid-moving pump (*see, e.g.,* FIGS. 2AC, 4A-B, 5, 6A-B, 7A-B, 8A-B, and 9A-B) or a wall or other surface (*see, e.g.,* FIGS. 10A-D and 11A-B). As mentioned above, the user interface 104 includes the interface cover 108 that may be opened or otherwise displaced to expose the second interface region 106b or closed or otherwise displaced to cover the second interface region 106b. In some embodiments, the interface cover 108 may be weather-resistant. For example, during inclement weather like rain, snow, and other forms of precipitation, the interface cover 108 may prevent the precipitation from damaging or otherwise interacting with the second interface region 106b. According to the invention, the first interface region 106a is exposed regardless of a position of the interface cover 108, thus providing quick access for a user to interface with this portion of the user interface 104.

The first interface region 106a may include any suitable number and/or types of interactive components such as a set of interactive components 110a-e as shown in FIGS. 1A-D. The interactive components 110 may include tangible or virtual buttons, dials, switches, touch screens, combinations thereof, or other suitable components for receiving input from a user. Interactive components 110a-e are in the form of buttons in the example shown in FIGS. 1A-D, although each of the interactive components need not be of the same type in other examples. Interactive components 110 may execute operations that cause a fluid-moving pump to perform certain functions. For example, one or more of the interactive components 110 may cause the fluid-moving pump to run, stop running, and/or pause running. One or more of the interactive components may also correspond to various long-term or other setting options. The setting options may include various options as desired, including but not limited to settings for affecting characteristics and/or operation of the fluid-moving pump. For example, the interactive components 110 may affect how long the fluid-moving pump will run, how long the fluid-moving pump will rest, how frequently the fluid-moving pump will run, a speed at which the fluid-moving pump will run, a combination thereof, or other desired settings. In some examples, pressing a button (or other interactive component) may select or execute operations corresponding to the pressed button (or other interactive component). In some examples, the first interface region 106a may be a quick-access interface in which a user can select one or more interactive components 110 for causing the fluid-moving pump to perform various operations without having to program the user interface 104 or the fluid-moving pump.

Referring to FIG. 1C, similar to the first interface region 106a, the second interface region 106b may include any suitable number and/or types of interactive tangible or virtual components for receiving input from a user (e.g., buttons, dials, switches, touch screens, combinations thereof, or others). The number and type of interactive components illustrated should not be considered limiting. According to the invention, and as illustrated in FIG. 1C, the second interface region 106b includes a screen 112 for displaying information relating to the fluid-moving pump to a user. For example, the screen 112 may be an illuminated screen (e.g., an LED-lit screen) that displays settings of the fluid-moving pump, programming options of the fluid-moving pump, and the like.

In certain embodiments, and as illustrated in FIG. 1C, the second interface region 106b may include a user interface dial 114 for adjusting settings of the fluid-moving pump. In some examples, the user interface dial 114 may be used to adjust settings and/or to create new or alternative programs of the fluid-moving pump, and the screen 112 may display the adjustments and/or the programs. In some examples, rotating the user interface dial 114 may change selections displayed by the screen 112 and depressing the user interface dial 114 may execute the selection displayed by the screen 112. For example, a user may adjust a long-term program of the user interface 104 called long-term program A. The user may rotate the user interface dial 114 until long-term program A is displayed, and the user may depress the user interface dial 114 to select long-term program A for accessing details about long-term program A and/or adjusting settings of long-term program A. Subsequent to selecting long-term program A, the user may rotate the user interface dial 114 to scroll through different settings of long-term program A and selecting one or more settings to adjust by depressing the user interface dial 114.

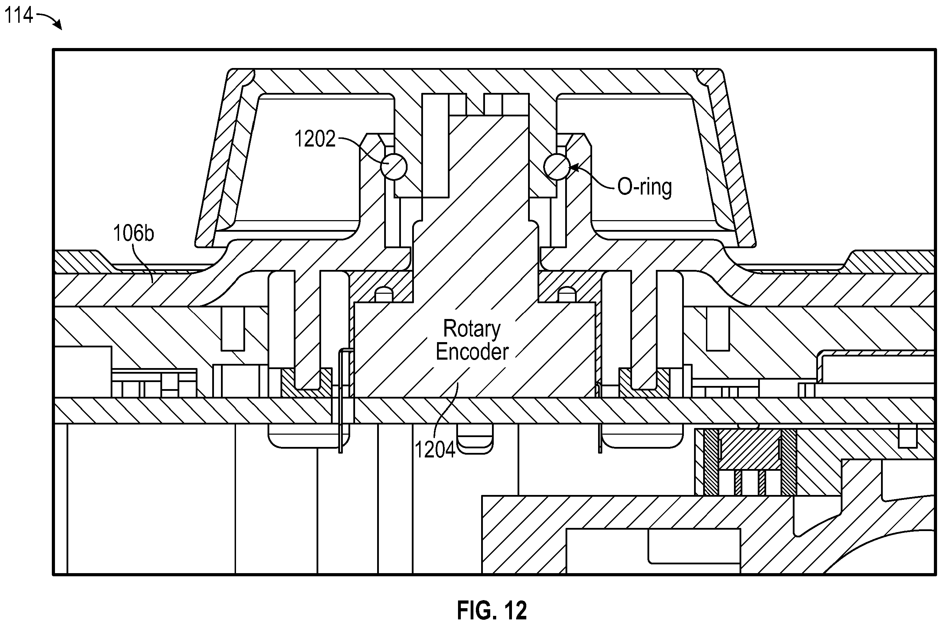

FIG. 12 is a cross-sectional view of the interface dial 114 described above. The interface dial 114 may include an O-ring 1202 that seals a rotary encoder 1204 from moisture or other debris that may damage the rotary encoder 1204 or the user interface 104. As described above, the interface dial 114 may be positioned on the second interface region 106b of the user interface 104 and may receive user input via rotation and depression. For example, the user may depress the user interface dial 114 to select an existing program, may rotate the user interface dial 114 to highlight a different setting of the existing program, and may depress the user interface dial 114 to select or execute the different setting.

Referring back to FIGS. 1A-D, in the embodiment illustrated, the second interface region 106b also includes two buttons 107a-b that can be used to control and/or adjust either the user interface 104 itself (e.g., turning the screen 112 on/off or displaying a menu of options) or a feature of the fluid-moving pump. Any number of buttons or other tangible or virtual interactive components may be included.

In certain embodiments, and as best illustrated in FIG. 1C, the interface cover 108 optionally may include a magnet 116 or other sensor positioned on an interior surface of the interface cover 108. The particular location of the sensor illustrated in FIG. 1C should not be considered limiting. The magnet 116 may be a typical magnet or may be a magnet sensor. In an example in which the magnet 116 is a typical magnet, upon closing the interface cover 108, the magnet 116 may exert a light (or minimum) force for retaining the interface cover 108 in a closed position until the user manually overcomes the magnetic force and opens the interface cover 108. In an example in which the magnet 116 is a magnet sensor, the magnet 116 may sense whether the interface cover 108 is open, and the magnet 116 may cause the screen 112 to illuminate in response to sensing that the interface cover 108 is open. Other sensors or closure features may be used in lieu or in addition to the magnet 116.

The user interface 104 may also include an interference feature such as, but not limited to, a nub 118 that may help hold the interface cover 108 in position (e.g., against the wall or fluid-moving pump when in the closed position and help retain the interface cover 108 in the open position when opened).

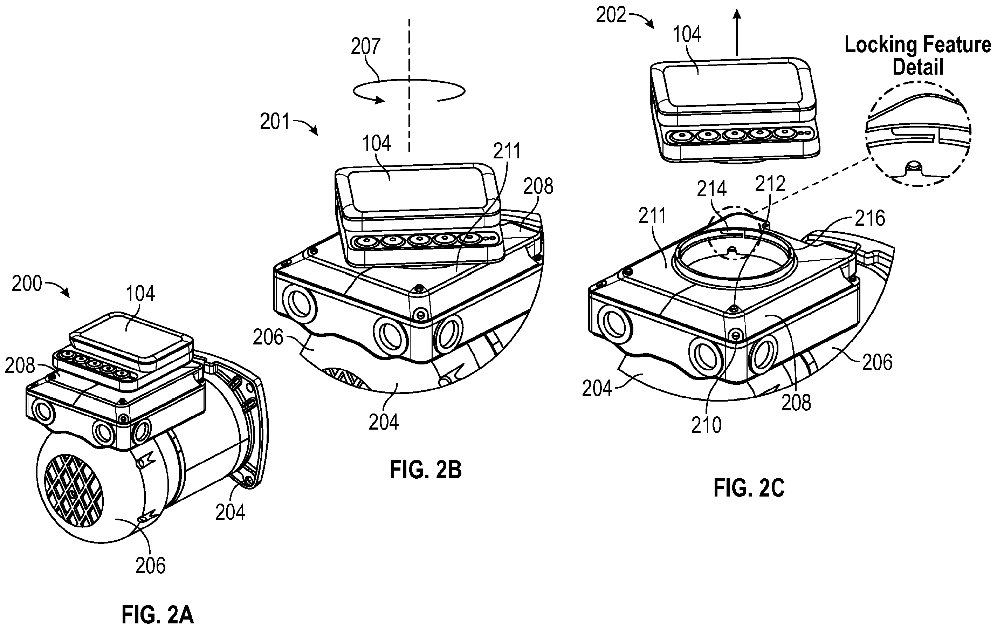

FIGS. 2A-C, 4A-B, 5, 6A-B, 7A-B, 8A-B, and 9A-B illustrate non-limiting examples of the user interface assembly 104 mounted on a fluid-moving pump to form a pump and user interface assembly.

FIGS. 2A-C illustrate various views 200-202 of a pump and user interface assembly 204 including the user interface assembly 104 mechanically coupled to a pump 206, such as a variable speed pump or any other suitable pump as desired. The pump 206 may be a swimming pool pump, a spa pump, a well pump, or any other suitable pump for moving fluid. The view 200 of FIG. 2A is a perspective view of the pump and user interface assembly 204, the view 201 of FIG. 2B is a perspective view of the pump and user interface assembly 204 in which the user interface 104 is in a different orientation compared to the user interface 104 of the view 200, and the view 202 of FIG. 2C is a perspective view of the pump and user interface assembly 204 with the user interface 104 detached from the pump 206. The user interface 104 may receive input, as described with respect to FIGS. 1A-D, from a user and/or an automation device for controlling the pump 206.

As illustrated in FIGS. 2A-C, in certain embodiments, a mounting cover 208 may attach or otherwise position the user interface 104 on or relative to the pump 206. In some embodiments, and as illustrated in FIGS. 2A-C, the mounting cover 208 may be positioned on a top portion of the pump 206. The mounting cover 208 may be affixed to, or otherwise positioned on, any other suitable location of the pump 206. The mounting cover 208 may be coupled to the pump 206 using any suitable mechanism or device as desired. In the embodiment illustrated and as best seen in FIG. 2C, mechanical fasteners such as a first set of screws 210 may couple the mounting cover 208 to the pump 206.

In certain embodiments and as best illustrated in FIGS. 2B-C, a hinge or attachment bracket or other hinge mechanism 211 may be affixed to the mounting cover 208. The hinge mechanism 211 may be attached to the mounting cover 208 using any suitable technique or mechanism as desired. In the embodiment illustrated, a second set of screws 212 attach the hinge mechanism 211 to the mounting cover 208. As described in more detail below, the attachment bracket 211 is movable with respect to the mounting cover 208 to selectively allow access to an interior of the pump and user interface assembly 204. As described in more detail below, the interior of the pump and user interface assembly 204 may house wiring that communicatively couples the user interface 104 with the pump 206.

The mounting cover 208 may be configured such that the user interface 104 can be affixed to, or otherwise positioned on, the pump 206 without using tools (i.e., tool-less assembly). For example, the user interface 104 may be (i) positioned on the mounting cover 208 and the attachment bracket 211 and (ii) rotated by about 90 degrees, or a quarter-turn, with respect to the pump 206 (represented by arrow 207 in FIG. 2B). Any other suitable number of degrees can be usable for rotating the user interface 104 to lock the user interface 104 on the mounting cover 208. The quarter-turn can, in some examples, lock the user interface 104 on the mounting cover 208 and the attachment bracket 211, which secures the user interface 104 in position on the pump 206.

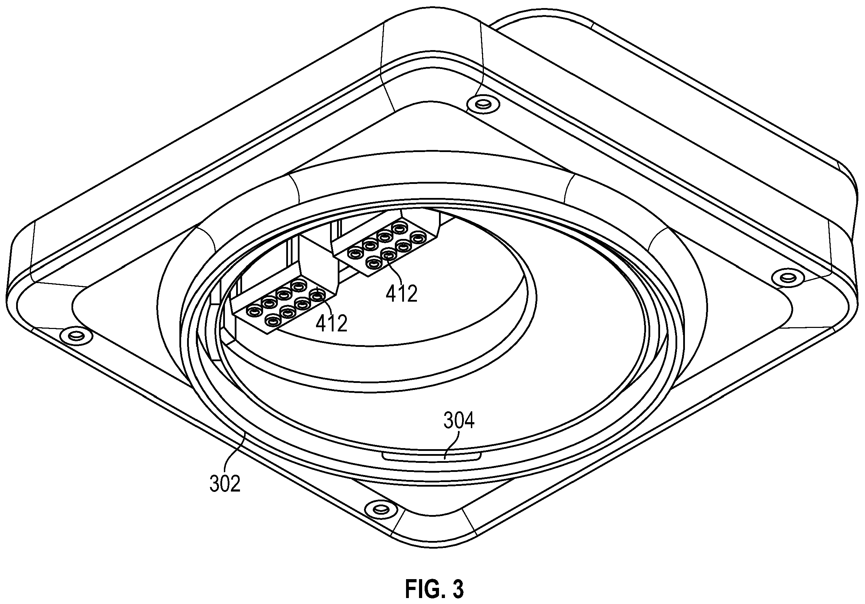

Referring to FIG. 3, in certain embodiments the underside of the user interface 104 may include an attachment interface 302. During assembly of the user interface 104 with the pump 206, the attachment interface 302 may cooperate with a corresponding attachment interface 216 of the attachment bracket 211 to lock the user interface 104 onto the mounting cover 208 to be positioned on the pump 206 (*see* FIG. 2C). In some embodiments, the attachment interface 302 may include at least two leads such as lead 304. The lead 304 allows the user interface 104 to interlock with the attachment bracket 211 (such as by the quarter-turn described above). For example, the user may position the user interface 104 on the attachment bracket 211 such that the lead 304 abuts a locking feature 214 of the attachment bracket 211. The locking feature 214 may guide the user interface 104 into a locked position subsequent to the user performing the quarter-turn. Increasing the number of leads 304 included in the attachment interface 302 increases a number of potential orientations of the user interface 104 relative to the pump 206 for the end user. For example, if the attachment interface 302 includes four leads 304, then an installer or other user may position the user interface 104 with respect to the mounting cover 208 in one of four different, predetermined orientations using quarter-turns. A different number of predetermined orientations may be provided by altering the number of leads provided.

Referring back to FIGS. 2A-C, the view 202 illustrates the user interface 104 before being positioned on the mounting cover 208 and the attachment bracket 211, the view 201 illustrates the user interface 104 being positioned on the mounting cover 208 and the attachment bracket 211, and the view 200 illustrates the user interface 104 affixed to the pump 206 subsequent to being rotated the quarter-turn to lock the user interface 104 on the mounting cover 208 and the attachment bracket 211. The view 200 illustrates the user interface 104 in one orientation, but, as described above, the user may position the user interface 104 on the pump 206 in any other suitable, predetermined orientation with respect to the pump 206. The attachment bracket 211 may additionally include a locking feature 214 that, subsequent to the user rotating the user interface 104 the quarter-turn, causes the user interface 104 to be locked on the mounting cover 208. As mentioned above, once the user interface 104 is installed on the pump 206, the user interface 104 is movable with respect to the pump 206 via the attachment bracket 211.

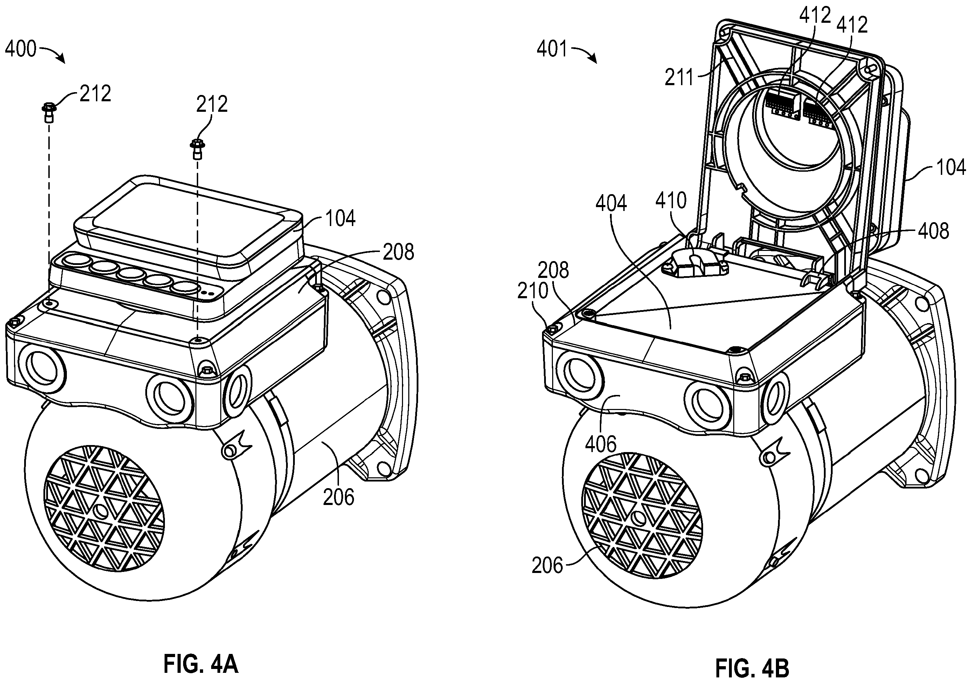

FIGS. 4AB show the pump and user interface assembly 204 in an open position (view 401 of FIG. 4A) and a closed position (view 400 of FIG. 4B). In some examples, a user may open the attachment bracket 211 by removing the second set of screws 212 from attachment bracket 211 and the mounting cover 208. Subsequently, the attachment bracket 211 may be lifted to expose an interior/wire region 404 of the mounting cover 208. In certain embodiments, the mounting cover 208 may be stationary with respect to the pump 206 regardless of whether the attachment bracket 211 is open or closed. In such embodiments, the mounting cover 208 optionally may be retained in position on a motor drive housing 406 of the pump 206 by the first set of screws 210. The attachment bracket 211 is movable relative to the mounting cover 208 using hinges 408 or other suitable features or mechanisms that connect the attachment bracket 211 and the mounting cover 208.

The interior/wire region 404 optionally may include a wire clamp 410 that retains one or more wires within the interior/wire region 404. As shown in FIGS. 3 and 4AB, the user interface 104 optionally may include one or more communication connections / connectors, for communicatively coupling the user interface 104, the pump 206, an automation device, a combination thereof, and/or any other suitable device for causing the pump 206 to operate. In the embodiment illustrated, the communication connections / connectors are RS-485 connectors 412; however, as mentioned, any other type of communication connections / connectors may be used as desired. In the example illustrated, the user interface 104 includes two RS-485 connectors 412, one of which connects the user interface 104 with the pump 206 and the other of which connects the user interface 104 with an automation or other device of the swimming pool, spa, or other body of water in which the pump 206 operates.

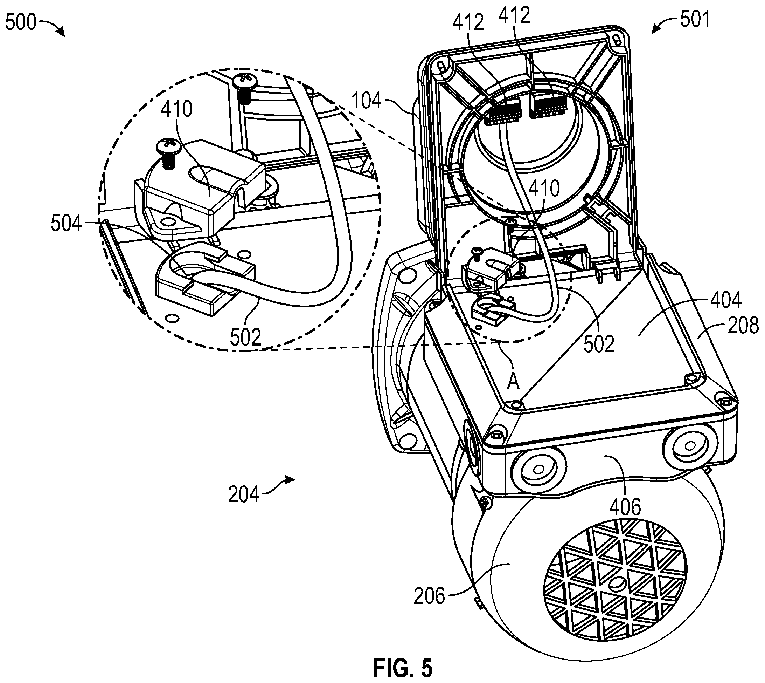

FIG. 5 illustrates two views 500 and 501 of a wire 502 that communicatively couples the user interface 104 to the pump 206 via one of the connectors 412. The view 500 is an enlarged view of the wire 502 and the wire clamp 410, and the view 501 is a perspective view of the pump and user interface assembly 204 that includes the wire 502. In certain embodiments, the wire 502 may be retained in the interior/wire region 404 via the wire clamp 410 in which the wire clamp 410 clamps or otherwise mechanically contacts the wire 502 to retain the wire 502 within the wire region 404. In some embodiments, the wire clamp 410 may be affixed to the mounting cover 208 using various mechanisms or devices as desired, including but not limited to mechanical fasteners such as screws. In some embodiments, the wire 502 may be directed through an access port 504 of the mounting cover 208. In certain embodiments, the wire clamp 410 may prevent or minimize water or other moisture from intruding into the motor drive housing 406 via the access port 504. The wire 502 may be directed through the access port 504 to the motor drive housing 406 and may be connected to one of the RS-485 connectors 412 for communicatively coupling the user interface 104 and the pump 206.

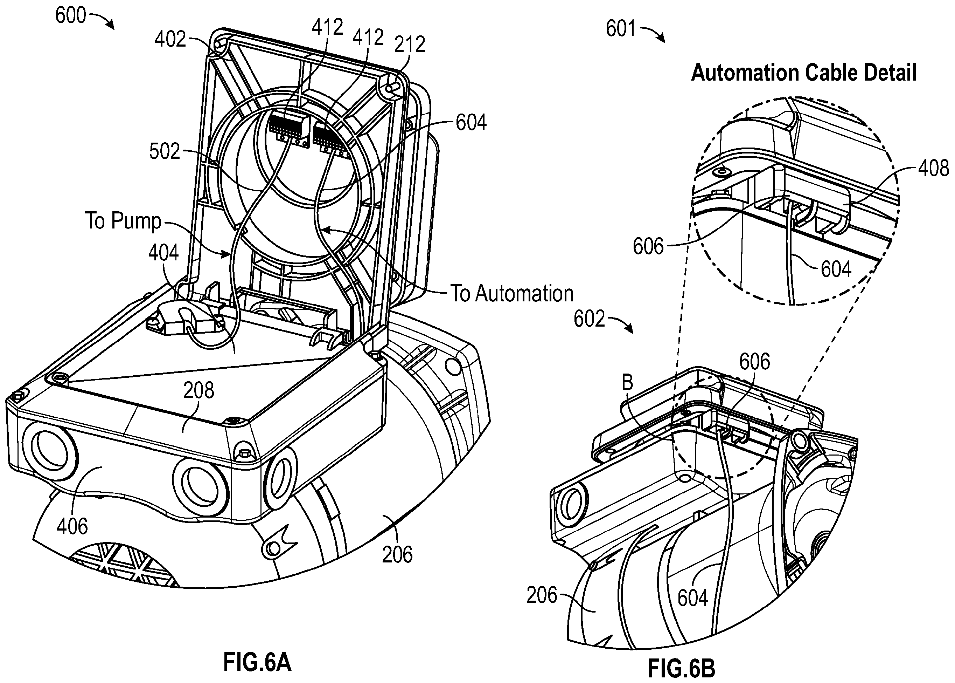

FIGS. 6A-B illustrate various views 600-602 of the pump and user interface assembly 204 that includes wire 502 as well as second wire 604 according to one or more examples of the present disclosure. The view 600 of FIG. 6A is a perspective view of the pump and user interface assembly 204 with the attachment bracket 211 in the open position and illustrating a second wire 604 extending from the second of the connector 412 into the interior/wire region 404. The view 601 of FIG. 6B is an enlarged view of a second access port 606, and the view 602 of FIG. 6B is a perspective view of the pump and user interface assembly 204 and the second wire 604.

In some examples, the wire 502 may be a first wire 502, and the second wire 604 may be connected to one of the RS-485 connectors 412. As illustrated in FIG. 6B, the second wire 604 may be directed through a second access port 606 for connecting to an automation or other device (not shown). In certain embodiments, the second access port 606 may be positioned proximate to, in, or around the hinge 408 that connects the mounting cover 208 and the attachment bracket 211. In this example, the automation device and the user interface 104 may be communicatively coupled to the pump 206. As illustrated, the first wire 502 and the second wire 604 are positioned parallel to one another. However, in some examples, the first wire 502 and the second wire 604 can be crossed in which the first wire 502 and the second wire 604 are connected to the opposite RS-485 connectors 412.

In certain embodiments, the system may allow the automation device to connect directly with the pump 206 without requiring connection through the user interface 104 (e.g., through a first path option), or the automation device can connect indirectly with the pump through the user interface 104 (e.g., through a second path option), thus creating a more modular system. With the first path option, an automation device may have its own user interface that connects directly to a pump (such as pump 206) to control the pump. In this configuration, the user interface 104 of the pump is not required, resulting in cost savings. With the second path option, the automation device connects to the user interface 104 of the pump 206, with the user interface 104 then connecting to the pump 206 or other suitable pump. This second path option is beneficial because it does not require access to the automation user interface to service the pump; instead an operator can use the user interface 104 of the pump to temporarily interrupt its connection to the user interface of the automation device, complete service on the automation device using the user interface 104, and then reestablish the connection between the user interface 104 and the user interface of the automation device. As noted above, because the system has a plurality of possible connection path options (e.g., the first path option, the second path option, etc.), the system is more flexible compared to traditional systems because the system can be operated through a desired connection path option (e.g., it can be operated through either the first path option or the second path option, depending on which is desired).

In some examples, the user may open the attachment bracket 211 by removing the second set of screws 212 for accessing the wire region 404 to adjust or rearrange the first wire 502 and/or the second wire 604 or to perform any other suitable operations relating to the interior/wire region 404 within the mounting cover 208.

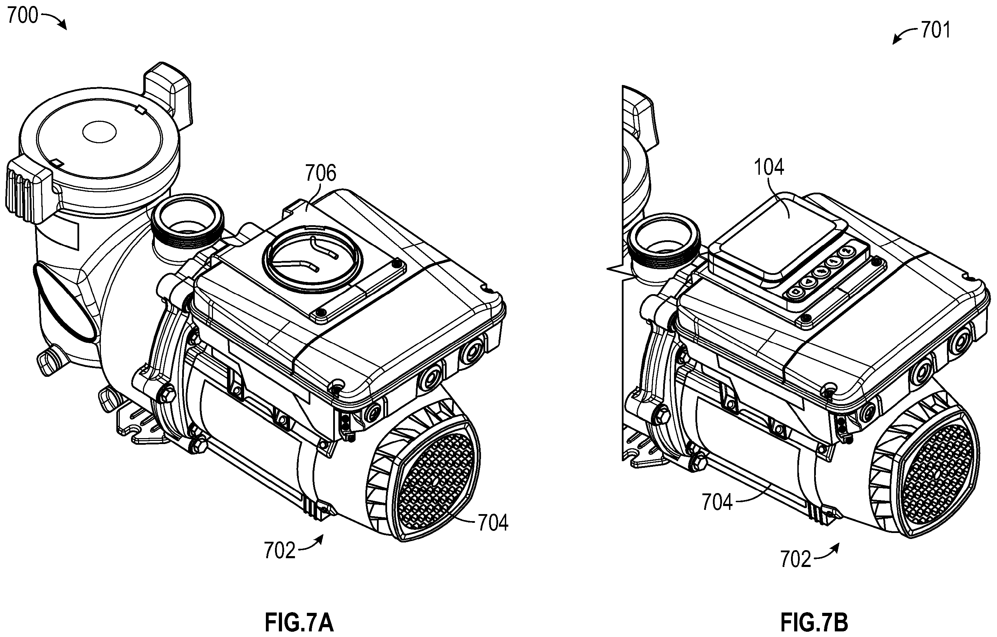

FIGS. 7A-B illustrate two views 700 and 701 of a pump and user interface assembly 702, including the user interface 104 described above coupled to a different pump 704. The view 700 of FIG. 7A is a perspective view of the pump and user interface assembly 702 without the user interface 104, and the view 701 of FIG. 7B is a perspective view of the pump and user interface assembly 702 that includes the user interface 104. The view 701 illustrates the user interface 104 positioned on the pump 704. The view 700 illustrates a attachment bracket 706 that can be used to affix or otherwise position the user interface 104 on the pump 704. The user interface 104 may be positioned on the pump 704 using the attachment bracket 706 in a method similar or identical to the method described with respect to FIGS. 2A-C and 3 relating to the quarter-turn.

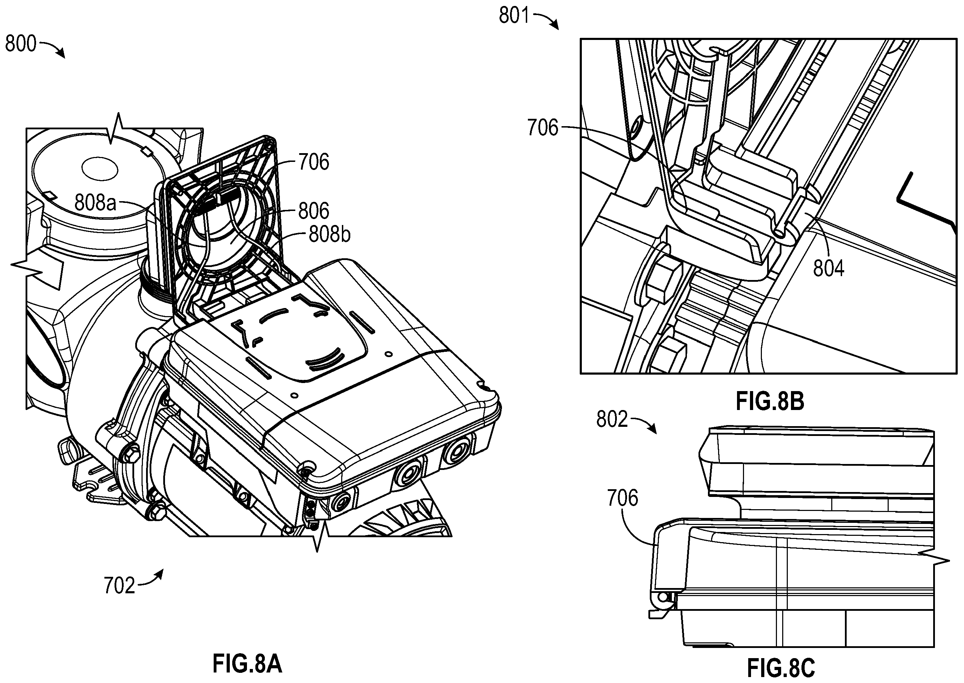

FIGS. 8AC illustrates various views 800-802 of the attachment bracket 706 of the pump and user interface assembly 702. The view 800 of FIG. 8A is a perspective view of the pump and user interface assembly 702, the view 801 of FIG. 8B is an enlarged view of a hinge 804 of the attachment bracket 706, and the view 802 of FIG. 8C is a side-view of the attachment bracket 706. The view 800 illustrates the pump and user interface assembly 702 with the attachment bracket 706 open, allowing a user to access a wire region 806 of the pump and user interface assembly 702. The hinge 804 may mechanically couple the attachment bracket 706 to the pump 704 and may allow the attachment bracket 706 to be opened for accessing the wire region 806. The wire region 806, similar to the wire region 404, may include two wires 808a-b for communicatively coupling the user interface 104 and an automation device (not shown) to the pump 704. The wire region 806 may include only one, or more than two, wires as desired.

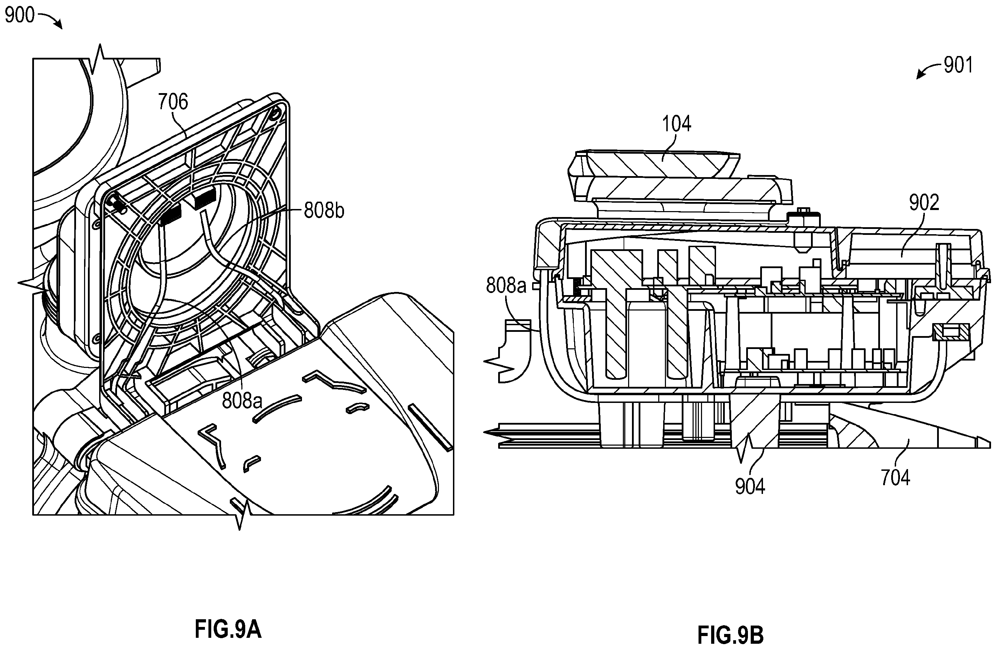

FIGS. 9A-B illustrate two views 900 and 901 of wires 808a-b that are included in the pump and user interface assembly 702. The view 900 of FIG. 9A is a perspective view of the attachment bracket 706 in an open position, and the view 901 of FIG. 9B is a cross-sectional side-view of a top portion 902 of the pump 704. The view 900 illustrates the attachment bracket 706 in an open position for accessing or otherwise exposing the wire region 806 of the attachment bracket 706. The wires 808 may be included in the wire region 806, retained in the wire region 806, or a combination thereof. The wire 808b may communicatively couple the pump 704 to the automation device. The wire 808a may communicatively couple the pump 704 to the user interface 104, and the wire 808a may be directed through a pump access 904 positioned underneath the user interface 104. As illustrated, the wires 808 are positioned parallel to one another. In some examples, the wires 808 are connected to the opposite RS-485 connectors such that the wires 808 are crossed.

As mentioned above, the user interface 104 may be mounted on a wall or other surface instead of directly on the pump. FIGS. 10A-D illustrates various views 1000-1003 of a wall mount 1004 and a user interface 104 according to one or more examples of the present disclosure. The view 1000 of FIG. 10A is a front-view of the wall mount 1004, the view 1001 of FIG. 10B is a perspective view of the wall mount 1004, the view 1002 of FIG. 10C is a side-view of the wall mount 1004, and the view 1003 of FIG. 10D is a perspective view of the wall mount 1004 and the user interface 104.

In certain embodiments, and as illustrated in the view 1000 of FIG. 10A, the wall mount 1004 has four leads 1006 that are similar or identical to the leads 304 described with respect to FIG. 3; however in other embodiments, the wall mount 1004 may include any number of leads 1006 as desired. The wall mount 1004 that includes the leads 1006 may allow the user interface 104 to be mounted on a wall via the wall mount 1004, in a manner similar or identical to the quarter-turn, in more than one orientation with respect to the wall. For example, if the wall mount includes four leads 1006, then the user interface 104 may be mounted on the wall mount 1004 in one of four different, predetermined orientations.

View 1003 of FIG. 10D illustrates the user interface 104 and the wall mount 1004. The wall mount 1004 may be affixed or otherwise positioned on the wall using any suitable mechanism or combinations of mechanisms as desired. In the embodiment illustrated, mechanical fasteners such as a set of screws 1008 are provided to affix the wall mount 1004 on a wall. The screws 1008 may mechanically couple the wall mount 1004 to the wall, and the user interface 104 may be mechanically coupled to the wall mount 1004. In some examples, the user interface 104 additionally can be communicatively coupled to the pump 206, the pump 704, or any other suitable pump for receiving input from the user interface 104.

FIGS. 11AB illustrate two views 1100 and 1101 of a user interface 104 mounted on a wall according to one or more examples of the present disclosure. The view 1100 of FIG. 11A is a perspective view of the user interface 104 mounted on the wall mount 1004 with the interface cover 108 open, and the view 1101 of FIG. 11B is a perspective view of the user interface 104 mounted on the wall mount 1004 with the interface cover 108 closed. As illustrated in FIG. 11A, when the interface cover 108 is open, both the first and second interface regions 106a,b are exposed. As mentioned, in some embodiments, the first interface region 106a may include the interactive components 110, and the second interface region 106b may include the interface dial 114 and other components described above. The user interface 104 of this example may be used, and may perform functions, similarly or identically as described with respect to FIGS. 1A-D. The user interface 104, in this example, is mechanically coupled to the wall mount 1004 for being positioned on the wall, and the user interface 104 may be communicatively coupled to the pump 206, the pump 704, or any other suitable pump for receiving input from the user interface 104 and/or to any other suitable device such as an automation device. In some embodiments, the user interface 104 may be communicatively coupled to the pump and to an automation system via wall wires 1102a-b that may be directed from the bottom of the user interface 104, such as from the RS-485 connector 412, to an input of the pump or an output of the automation system.

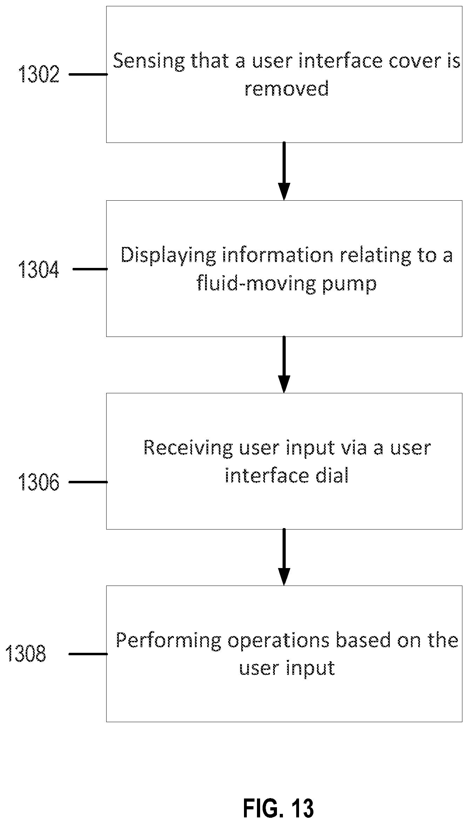

FIG. 13 is a flow chart of a process 1300 for operating a user interface that includes two interface regions according to one or more examples of the present disclosure. At block 1302, the process 1300 involves the user interface 104 detecting that the interface cover 108 is open. A sensor (such as magnet 116) may communicate with the user interface 104 for determining that the interface cover 108 is open.

At block 1304, the process involves the user interface 104 displaying information relating to a pump, such as the pump 206, the pump 704, or any other suitable pump. In response to sensing that the interface cover 108 is open, the user interface 104 may illuminate the screen 112 and display information relating to the pump on the screen 112. The information may include pump settings such as long-term or other settings, pump functions, and the like.

At block 1306, the process involves the user interface 104 of a first of the two interface regions receiving user input via the user interface dial 114 or other interactive component of either the first or second of the two interface regions. The user interface dial 114 may be rotated to change a displayed option and depressed to indicate selection of a displayed option. The user interface dial 114 may be rotated and depressed suitable amounts of time for selecting settings or programs to customize and for adjusting the settings or programs.

At block 1308, the process involves the user interface 104 performing operations in response to the user input from the user interface dial 114 or other interactive component. For example, if the user input from the user interface dial 114 indicates that a long-term program is to be updated and run, the user interface 104 may update the long-term program and may cause the pump to perform operations included in the long-term program.

Different arrangements of the components depicted in the drawings or described above, as well as components and steps not shown or described, are possible. Similarly, some features and sub-combinations are useful and may be employed without reference to other features and sub-combinations. Embodiments of the invention have been described for illustrative and not restrictive purposes, and alternative embodiments may become apparent to readers of this patent. Accordingly, the present invention is not limited to the embodiments described above or depicted in the drawings, and various embodiments and modifications may be made without departing from the scope of the claims below. Additionally, the phrase "swimming pool" as used herein may include vessels such as spas and hot tubs within its definition.

## Claims

1. A user interface (104) for a fluid-moving pump (206), the user interface (104) comprising a first interface region (106a), a second interface region (106b), and a cover (108) for selectively covering the second interface region (106b), wherein the cover (108) is movable between a closed position and an open position, in the open position, both the first interface region (106a) and the second interface region (106b) are exposed, and, in the closed position, the second interface region (106b) is covered and the first interface region (106a) is exposed, wherein the first interface region (106a) comprises a first type of interactive component (110a-e), and wherein the second interface region (106b) comprises a second type of interactive component (112, 114) different from the first type of interactive component (110a-e), and wherein the second type of interactive component (112, 114) comprises a screen (112).

2. The user interface (104) of claim 1, wherein the second type of interactive component comprises an interface dial (114).

3. A user interface assembly (104) for a fluid-moving pump (206), the user interface assembly (104) comprising a user interface (104) according to claim 1, in which the user interface (104) is attachable to the fluid-moving pump (206) and without use of tools.

4. The user interface assembly (104) of claim 3, further comprising a mounting cover (208) and an attachment bracket (211), wherein the user interface (104) is secured to the mounting cover (208) and the attachment bracket (211) without the use of tools, wherein the user interface (104) preferably comprises a first attachment interface (302), and wherein the attachment bracket preferably comprises a second attachment interface (216) configured to cooperate with the first attachment interface (302) to attach the user interface (104) to the mounting cover (208) and the attachment bracket (211).

5. The user interface (104) of claim 1, the user interface further comprising at least two communication connections (412) for communicatively coupling the user interface (104) to the fluid-moving pump (206) and to an automation device.

6. The user interface (104) of claim 5, wherein the at least two communication connections (412) comprise RS-485 connections.

7. A user interface assembly (104) comprising the user interface of claim 5, a mounting cover (208), and a wire (502) connected to one of the at least two communication connections (412), wherein the mounting cover (208) comprises a wire region (404) and defines an access port (504), wherein the wire (502) is at least partially retained in the wire region (404) via a wire clamp (410) and is directed through the access port (504).

8. A user interface assembly (104) for a fluid-moving pump (206), the user interface assembly comprising a user interface (104) according to claim 1, the user interface being configured to be mounted on a wall or a pump and oriented into one of four or more predetermined orientations relative to the wall or the pump.

9. The user interface assembly (104) of claim 8, further comprising a mounting cover (208) configured to attach the user interface (104) on the wall or the pump, and an attachment bracket (211) on the mounting cover (208), wherein the user interface (104) is attachable to the attachment bracket (211), wherein the attachment bracket (211) preferably comprises a locking feature (214), wherein the user interface preferably comprises a plurality of leads (304), and wherein each of the four or more predetermined orientations comprises an abutment of the locking feature (214) of the attachment bracket (211) with a particular lead (304) of the plurality of leads.

10. A method associated with a user interface (104) for a fluid-moving pump (206), the method comprising:
sensing that a cover (108) of a second interface region (106b) is open, wherein the user interface (104) comprises a first interface region (106a), the second interface region (106b), and the cover (108) for selectively covering the second interface region (106b), wherein the cover (108) is movable between a closed position and an open position, wherein, in the open position, both the first interface region (106a) and the second interface region (106b) are exposed, and, in the closed position, the second interface region (106b) is covered and the first interface region (106a) is exposed, wherein the first interface region (106a) comprises a first type of interactive component (110a-e), and wherein the second interface region (106b) comprises a second type of interactive component (112, 114) different from the first type of interactive component (110a-e), and wherein the second type of interactive component (112, 114) comprises a screen (112);
displaying information relating to the fluid-moving pump (206),
receiving user input via a user interface dial (114), and performing operations based on the received user input.

11. The method of claim 10, wherein receiving the user input comprises receiving a rotation of the user interface dial (114) or receiving a depression of the user interface dial (114).

12. A system comprising a fluid-moving pump (206), a user interface (104) according to claim 1, and an attachment bracket (211) for positioning the user interface (104) on the fluid-moving pump (206), wherein the attachment bracket (211) is movable between an open position and a closed position to selectively allow access to an interior of the system housing wires connecting the user interface (104) with the fluid-moving pump (206).

13. The system of claim 12, wherein the user interface (104) is mounted on the attachment bracket (211) and oriented into one of four or more predetermined orientations relative to the fluid-moving pump (206), and/or wherein the attachment bracket (211) comprises a first access port (504), a second access port (606), and a hinge (408), and wherein the second access port is positioned in the hinge.

## Patentansprüche

1. Benutzerinterface (104) für eine Fluidförderpumpe (206), wobei das Benutzerinterface (104) einen ersten Interfacebereich (106a), einen zweiten Interfacebereich (106b) und eine Abdeckung (108) zum selektiven Abdecken des zweiten Interfacebereichs (106b) umfasst, wobei die Abdeckung (108) zwischen einer geschlossenen Position und einer offenen Position bewegbar ist, in der offenen Position sowohl der erste Interfacebereich (106a) als auch der zweite Interfacebereich (106b) freiliegen und in der geschlossenen Position der zweite Interfacebereich (106b) abgedeckt ist und der erste Interfacebereich (106a) freiliegt, wobei der erste Interfacebereich (106a) eine erste Art einer interaktiven Komponente (110a-e) umfasst, und wobei der zweite Interfacebereich (106b) eine zweite Art einer interaktiven Komponente (112, 114) umfasst, die sich von der ersten Art einer interaktiven Komponente (110a-e) unterscheidet, und wobei die zweite Art einer interaktiven Komponente (112, 114) einen Bildschirm (112) umfasst.

2. Benutzerinterface (104) nach Anspruch 1, wobei die zweite Art einer interaktiven Komponente eine Interface-Wähleinrichtung (114) umfasst.

3. Benutzerinterface-Baugruppe (104) für eine Fluidförderpumpe (206), wobei die Benutzerinterface-Baugruppe (104) ein Benutzerinterface (104) gemäß Anspruch 1 umfasst, wobei das Benutzerinterface (104) ohne Verwendung eines Werkzeugs an der Fluidförderpumpe (206) befestigbar ist .

4. Benutzerinterface-Baugruppe (104) nach Anspruch 3, die ferner eine Montageabdeckung (208) und eine Befestigungshalterung (211) umfasst, wobei das Benutzerinterface (104) ohne die Verwendung von Werkzeugen an der Montageabdeckung (208) und der Befestigungshalterung (211) befestigt ist, wobei das Benutzerinterface (104) vorzugsweise eine erste Befestigungsschnittstelle (302) umfasst, und wobei die Befestigungshalterung vorzugsweise eine zweite Befestigungsschnittstelle (216) umfasst, die so ausgelegt ist, dass sie mit der ersten Befestigungsschnittstelle (302) zusammenwirkt, um das Benutzerinterface (104) an der Montageabdeckung (208) und der Befestigungshalterung (211) zu befestigen.

5. Benutzerinterface (104) nach Anspruch 1, wobei das Benutzerinterface ferner mindestens zwei Kommunikationsverbindungen (412) umfasst, um das Benutzerinterface (104) kommunikativ mit der Fluidförderpumpe (206) und mit einer Automatisierungsvorrichtung zu verbinden.

6. Benutzerinterface (104) nach Anspruch 5, wobei die mindestens zwei Kommunikationsverbindungen (412) RS-485 Verbindungen umfassen.

7. Benutzerinterface-Baugruppe (104), umfassend das Benutzerinterface nach Anspruch 5, eine Montageabdeckung (208) und einen Draht (502), der mit einer der wenigstens zwei Kommunikationsverbindungen (412) verbunden ist, wobei die Montageabdeckung (208) einen Drahtbereich (404) umfasst und eine Zugangsöffnung (504) definiert, wobei der Draht (502) zumindest teilweise über eine Drahtklemme (410) in dem Drahtbereich (404) gehalten und durch die Zugangsöffnung (504) geführt ist.

8. Benutzerinterface-Baugruppe (104) für eine Fluidförderpumpe (206), wobei die Benutzerinterface-Baugruppe ein Benutzerinterface (104) gemäß Anspruch 1 umfasst, wobei das Benutzerinterface so ausgelegt ist, dass es an einer Wand oder einer Pumpe montiert und in eine von vier oder mehr vorgegebenen Ausrichtungen relativ zu der Wand oder der Pumpe ausgerichtet werden kann.

9. Benutzerinterface-Baugruppe (104) nach Anspruch 8, die ferner eine Montageabdeckung (208), die dazu ausgelegt ist, das Benutzerinterface (104) an der Wand oder der Pumpe zu befestigen, und eine Befestigungshalterung (211) an der Montageabdeckung (208) umfasst, wobei das Benutzerinterface (104) an der Befestigungshalterung (211) befestigbar ist, wobei die Befestigungshalterung (211) vorzugsweise eine Verriegelungseinrichtung (214) umfasst, wobei das Benutzerinterface vorzugsweise eine Mehrzahl von Vorsprüngen (304) umfasst und wobei jede der vier oder mehr vorgegebenen Ausrichtungen ein Anliegen des Verriegelungseinrichtung (214) der Befestigungshalterung (211) an einem bestimmten Vorsprung (304) aus der Mehrzahl der Vorsprünge umfasst.

10. Verfahren in Zusammenhang mit einem Benutzerinterface (104) für eine Fluidförderpumpe (206), wobei das Verfahren umfasst:
Erkennen, dass eine Abdeckung (108) eines zweiten Interfacebereichs (106b) geöffnet ist, wobei das Benutzerinterface (104) einen ersten Interfacebereich (106a), den zweiten Interfacebereich (106b) und die Abdeckung (108) zum selektiven Abdecken des zweiten Interfacebereichs (106b) umfasst, wobei die Abdeckung (108) zwischen einer geschlossenen Position und einer offenen Position bewegbar ist, wobei in der offenen Position sowohl der erste Interfacebereich (106a) als auch der zweite Interfacebereich (106b) freiliegen und in der geschlossenen Position der zweite Interfacebereich (106b) abgedeckt und der erste Interfacebereich (106a) freiliegt, wobei der erste Interfacebereich (106a) eine erste Art einer interaktiven Komponente (110a-e) umfasst, und wobei der zweite Interfacebereich (106b) eine zweite Art einer interaktiven Komponente (112, 114) umfasst, der sich von der ersten Art einer interaktiven Komponente (110a-e) unterscheidet, und wobei die zweite Art einer interaktiven Komponente (112, 114) einen Bildschirm (112) umfasst;
Anzeigen von Informationen in Bezug auf die Fluidförderpumpe (206),
Empfangen einer Benutzereingabe über eine Benutzerinterface-Wähleinrichtung (114) und Ausführen von Vorgängen auf der Grundlage der empfangenen Benutzereingabe.

11. Verfahren nach Anspruch 10, wobei das Empfangen der Benutzereingabe das Empfangen einer Drehung der Benutzerinterface-Wähleinrichtung (114) oder das Empfangen eines Niederdrückens der Benutzerinterface-Wähleinrichtung (114) umfasst.

12. System, umfassend eine Fluidförderpumpe (206), ein Benutzerinterface (104) gemäß Anspruch 1 und eine Befestigungshalterung (211) zum Positionieren des Benutzerinterface (104) an der Fluidförderpumpe (206), wobei die Befestigungshalterung (211) zwischen einer offenen Position und einer geschlossenen Position bewegbar ist, um wahlweise Zugang zu einem Inneren des Systems zu gewähren, in welchem Drähte untergebracht sind, die das Benutzerinterface (104) mit der Fluidförderpumpe (206) verbinden.

13. System nach Anspruch 12, wobei das Benutzerinterface (104) an der Befestigungshalterung (211) angebracht und in eine von vier oder mehr vorgegebenen Ausrichtungen relativ zu der Fluidförderpumpe (206) ausgerichtet ist, und/oder wobei die Befestigungshalterung (211) eine erste Zugangsöffnung (504), eine zweite Zugangsöffnung (606) und ein Scharnier (408) umfasst, und wobei die zweite Zugangsöffnung in dem Scharnier angeordnet ist.

## Revendications

1. Interface utilisateur (104) pour une pompe de déplacement de fluide (206), l'interface utilisateur (104) comprenant une première zone d'interface (106a), une seconde zone d'interface (106b), et un couvercle (108) pour recouvrir sélectivement la seconde zone d'interface (106b), dans laquelle le couvercle (108) est mobile entre une position fermée et une position ouverte,
dans la position ouverte, à la fois la première zone d'interface (106a) et la seconde zone d'interface (106b) sont exposées, et, dans la position fermée, la seconde zone d'interface (106b) est recouverte et la première zone d'interface (106a) est exposée, dans laquelle la première zone d'interface (106a) comprend un premier type de composant interactif (110a-e), et dans laquelle la seconde zone d'interface (106b) comprend un second type de composant interactif (112, 114) différent du premier type de composant interactif (110a-e), et dans laquelle le second type de composant interactif (112, 114) comprend un écran (112).

2. Interface utilisateur (104) selon la revendication 1, dans laquelle le second type de composant interactif comprend un cadran d'interface (114).

3. Ensemble interface utilisateur (104) pour une pompe de déplacement de fluide (206), l'ensemble interface utilisateur (104) comprenant une interface utilisateur (104) selon la revendication 1, dans lequel l'interface utilisateur (104) peut être fixée à la pompe de déplacement de fluide (206) et sans utilisation d'outils.

4. Ensemble interface utilisateur (104) selon la revendication 3, comprenant en outre un couvercle de montage (208) et un support de fixation (211), dans lequel l'interface utilisateur (104) est arrimée au couvercle de montage (208) et au support de fixation (211) sans l'utilisation d'outils, dans lequel l'interface utilisateur (104) comprend de préférence une première interface de fixation (302), et dans lequel le support de fixation comprend de préférence une seconde interface de fixation (216) configurée pour coopérer avec la première interface de fixation (302) afin de fixer l'interface utilisateur (104) au couvercle de montage (208) et au support de fixation (211).

5. Interface utilisateur (104) selon la revendication 1, l'interface utilisateur comprenant en outre au moins deux connexions de communication (412) pour coupler en communication l'interface utilisateur (104) à la pompe de déplacement de fluide (206) et à un dispositif d'automatisation.

6. Interface utilisateur (104) selon la revendication 5, dans laquelle les au moins deux connexions de communication (412) comprennent des connexions RS-485.

7. Ensemble interface utilisateur (104) comprenant l'interface utilisateur selon la revendication 5, un couvercle de montage (208), et un fil (502) connecté à l'une des au moins deux connexions de communication (412), dans lequel le couvercle de montage (208) comprend une zone de fil (404) et définit un orifice d'accès (504), dans lequel le fil (502) est au moins partiellement retenu dans la zone de fil (404) par l'intermédiaire d'un serre-fil (410) et est dirigé à travers l'orifice d'accès (504).

8. Ensemble interface utilisateur (104) pour une pompe de déplacement de fluide (206), l'ensemble interface utilisateur comprenant une interface utilisateur (104) selon la revendication 1, l'interface utilisateur étant configurée pour être montée sur une paroi ou une pompe et orientée selon l'une de quatre orientations prédéterminées ou plus par rapport à la paroi ou à la pompe.

9. Ensemble interface utilisateur (104) selon la revendication 8, comprenant en outre un couvercle de montage (208) configuré pour fixer l'interface utilisateur (104) sur la paroi ou la pompe, et un support de fixation (211) sur le couvercle de montage (208), dans lequel l'interface utilisateur (104) peut être fixée au support de fixation (211), dans lequel le support de fixation (211) comprend de préférence un élément de verrouillage (214), dans lequel l'interface utilisateur comprend de préférence une pluralité de conducteurs (304), et dans lequel chacune des quatre orientations prédéterminées ou plus comprend une butée de l'élément de verrouillage (214) du support de fixation (211) avec un conducteur particulier (304) de la pluralité de conducteurs.

10. Procédé associé à une interface utilisateur (104) pour une pompe de déplacement de fluide (206), le procédé comprenant :
la détection qu'un couvercle (108) d'une seconde zone d'interface (106b) est ouvert, dans lequel l'interface utilisateur (104) comprend une première zone d'interface (106a), la seconde zone d'interface (106b), et le couvercle (108) pour recouvrir sélectivement la seconde zone d'interface (106b), dans lequel le couvercle (108) est mobile entre une position fermée et une position ouverte, dans lequel, dans la position ouverte, à la fois la première zone d'interface (106a) et la seconde zone d'interface (106b) sont exposées, et, dans la position fermée, la seconde zone d'interface (106b) est recouverte et la première zone d'interface (106a) est exposée, dans lequel la première zone d'interface (106a) comprend un premier type de composant interactif (110a-e), et dans lequel la seconde zone d'interface (106b) comprend un second type de composant interactif (112, 114) différent du premier type de composant interactif (110a-e), et dans lequel le second type de composant interactif (112, 114) comprend un écran (112) ;
l'affichage d'informations relatives à la pompe de déplacement de fluide (206),
la réception d'une entrée utilisateur par l'intermédiaire d'un cadran d'interface utilisateur (114), et la réalisation d'opérations sur la base de l'entrée utilisateur reçue.

11. Procédé selon la revendication 10, dans lequel la réception de l'entrée utilisateur comprend la réception d'une rotation du cadran d'interface utilisateur (114) ou la réception d'un enfoncement du cadran d'interface utilisateur (114).

12. Système comprenant une pompe de déplacement de fluide (206), une interface utilisateur (104) selon la revendication 1, et un support de fixation (211) pour positionner l'interface utilisateur (104) sur la pompe de déplacement de fluide (206), dans lequel le support de fixation (211) est mobile entre une position ouverte et une position fermée pour permettre sélectivement l'accès à un intérieur du système logeant des fils connectant l'interface utilisateur (104) à la pompe de déplacement de fluide (206).

13. Système selon la revendication 12, dans lequel l'interface utilisateur (104) est montée sur le support de fixation (211) et orientée selon l'une de quatre orientations prédéterminées ou plus par rapport à la pompe de déplacement de fluide (206), et/ou dans lequel le support de fixation (211) comprend un premier orifice d'accès (504), un second orifice d'accès (606), et une charnière (408), et dans lequel le second orifice d'accès est positionné dans la charnière.
